# EUROPEAN PATENT SPECIFICATION

(11) **EP 3 557 959 B1**
(45) Date of publication and mention of the grant of the patent: **01.07.2020**
(21) Application number: 19170172.1
(22) Date of filing: 18.04.2019
(51) Int. Cl.: H05K 5/06

(54) **WATERPROOF POWER SUPPLY**
WASSERDICHTE STROMVERSORGUNG
ALIMENTATION ÉTANCHE À L'EAU

(30) Priority: 20.04.2018 CN 201810364790
(43) Date of publication of application: 23.10.2019
(73) Proprietor: Self Electronics Co., Ltd., Ningbo City, Zhejiang 315103 (CN); SELF ELECTRONICS Germany GmbH, 51149 Köln (DE); Lin, Wanjiong, Ningbo City, Zhejiang 315103 (CN)
(72) Inventor: ZENG, Guoqing, Ningbo, 315103 (CN)
(74) Representative: 2K Patentanwälte Blasberg Kewitz & Reichel

(56) References cited:
- EP-A1- 3 177 119
- CN-U- 203 784 891
- JP-A- 2007 207 768

## Description

### FIELD OF THE TECHNOLOGY

The present invention relates to electronic field, with particular emphasis on a waterproof power supply.

### BACKGROUND OF THE INVENTION

At present, the waterproof power supply on the market is mainly used to pour the potting glue into the power supply or to set the silicone gasket in the power supply to achieve a waterproof effect.

The former waterproof method is to vacuum the inside of the power supply before filling the glue, and then refill the glue, vacuuming can avoid the air holes in the no-fill sealant, which makes it possible for water vapor to enter through the air holes to short-circuit the components in the power supply;

The invention patent CN102055303B mainly embodies the latter waterproof method, that is, the waterproof gasket is set in the power supply device for waterproof.

JP 2007 207768 A discloses a waterproof structure of a tubular case end. A hollow is provided on an outer peripheral surface of a sealing plug inserted into the tubular case end, a filling material is injected from a hole provided on an outer surface of the sealing plug in the hollow and a space part formed on an inner face of the tubular case, the tubular case is formed with a structure discharging the air in the space part from a groove or a hole of the sealing plug formed independently, and a waterproof case covers its outside to make up the waterproof structure.

CN 203 784 891 U discloses a waterproof drive power supply comprising a housing with openings at the two ends, and a power panel fixedly mounted in the housing; the two ends of the power panel are connected with conducting wires respectively; an end cover is arranged at the opening of each end of the housing; conducting wire holes are formed in each end cover; an inner plug nested in the housing and provided with openings is arranged between the end cover and the power panel which are positioned on the same side, and a gap is reserved between the inner plug and the end cover to form a glue injection cavity; glue injection holes communicated with the glue injection cavities are formed in the housing; sealant blocks formed by injection molding are arranged in the glue injection cavities. According to the utility model, not only are waterproof and fog-proof effects ensured, but also the consumption of glue is only 20% of the consumption of glue used in the prior art, the curing time is greatly shortened, the production efficiency is improved, the direct contact between glue and an electric element is prevented, and the phenomenathat the displacement caused by tension generated by thermal expansion and cold shrinkage of the glue to the electric element, of the electric element is caused, the glue cracks after curing, and the electric element directly suffers from corrosion damage can be avoided, thereby improving the stability of the product quality, and reducing the cost.

EP 3 177 119 A1 discloses a waterproof case for an electrical apparatus, a power supply unit, and to a corresponding method of assembling an electrical apparatus. The waterproof case comprises a case body which defines an inner space for accommodating an electrically functional component and which comprises at least one first opening, at least one first plug which is mounted in said first opening to form a first part of a wall of the inner space, wherein the first plug comprises at least one first terminal conduit forming a feedthrough for a first terminal. The first plug is arranged in said first opening to form with said case body a first external space, and said first external space is filled with an electrically insulating material for sealing said waterproof case.

### BRIEF SUMMARY OF THE INVENTION

In the actual production process, the applicant found that the way of putting the glue in the power supply is feasible, but due to the vacuuming operation is need to carry out beforehand, which makes the power production process complicated and the production efficiency low; the method of setting the gasket is simple, and the requirement of the device is not high, but there is a problem that the gasket and the power supply are not tightly sealed, and the silica gel is easily aged, which also makes the waterproof effect of the power supply is greatly reduced.

In view of the above problems, an object of the present invention is to provide a waterproof power supply which has good waterproof effect and high production efficiency.

The invention also aims to provide a waterproof power supply with simple structure.

In order to achieve the above purposes, the technical scheme of the invention is: a waterproof power supply, including,
housing, the housing is provided with built-in power supply component;
end cover, the end cover is connected to the opening on the housing;
the end cover and the opening of the housing form a sealed cavity and the sealing of end cover and housing can be realized by injecting colloid into the cavity.

Further, the end cover includes two oppositely disposed and connected baffles, and the cavity is formed by the enclosure of two baffles and the side wall of the housing.

The two baffles are conductive plates and are electrically connected; the power supply component is a circuit motherboard, the baffle on the inner side of the end cover is connected with one end of the circuit motherboard; the end cover is further provided with power cord, and the power cord is connected at least to the baffle on the outer side of the end cover, and the two baffles are connected through a conductive connector.

Advantageously, the baffle on the outer side of the end cover is provided with injection hole and overflow hole, the colloid is injected into the cavity from the injection hole, the air in the cavity is discharged from the overflow hole during the injection process, and the colloid overflows from the overflow hole after the colloid is filled with the cavity.

Advantageously, the housing is integrally formed.

Advantageously, two openings are formed on the housing, respectively located at two ends of the housing.

Advantageously, two baffles are integrally formed.

Compared with the prior art, the invention has the advantages that the end cover and the opening of the housing form a cavity, and the end cover is provided with injection hole and overflow hole, when the colloid is injected through the injection hole, the air in the cavity is continuously eliminated from the overflow hole in the process of colloid injection. When the colloid is filled, it will overflow from the overflow hole. The structure effectively overcomes the complicated process of removing gas from the housing by vacuuming, which is convenient and fast, and the cost is low, and the effect is good; Meanwhile, the entire power supply is in contact with the circuit board through the conductive plate of the end cover, that is to achieve the conductive transmission of power, this structure simplifies the internal structure of the power supply, but also firm and stable, reduce the production cost.

### BRIEF DESCRIPTION OF THE DRAWINGS

The drawings described herein are intended to promote a further understanding of the present invention, as follows:
FIG. 1 is a schematic structural view of a waterproof power supply according to an embodiment of the present invention.
FIG. 2 is an angular exploded view of FIG. 1.
FIG. 3 is a sectional view along a-a direction after removing the power cord at one end of the power supply in FIG. 1.

### DETAILED DESCRIPTION OF THE INVENTION

Embodiments of the invention are described in detail below, Examples of the embodiments are shown in the appended drawings in which consistently identical or similar labels represent identical or similar elements or elements having the same or similar function. The embodiments described below by reference to the drawings are exemplary and are only used for the interpretation of the invention and cannot be understood to be a limitation of the invention.

The present application relates to a waterproof power supply including a housing 1 having a power supply component 2 disposed therein, the housing 1 is provided with an opening 11. The waterproof power supply also includes end cover 3 which is connected to the opening 11 on the housing 1. The end cover 3 and the opening 11 of the housing 1 can cooperate to form a relatively sealed cavity in the present application, and the sealing of end cover and housing can be realized by injecting colloid into the cavity, and then the whole housing can be sealed for effective waterproof.

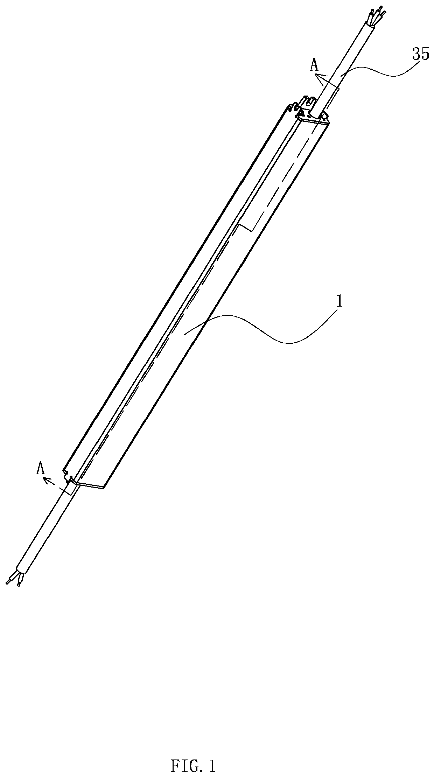

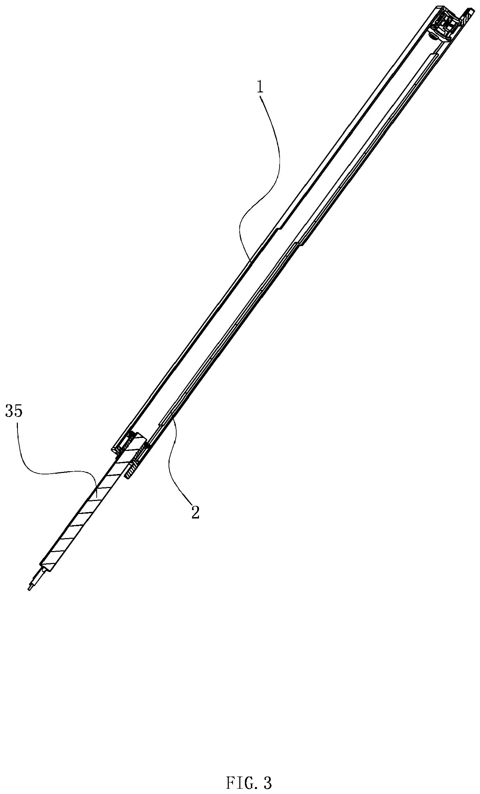

FIG.1-3 shows a structural diagram of the waterproof power supply of the present invention, but it needs to be noted that here is one embodiment structure of the present invention is shown here, but not limited to this structure, other power structures that can achieve the functions and effects described in this application also fall within the scope of protection of this application.

In this embodiment, the end cover 3 includes two oppositely disposed and connected baffles 31, 32, and the cavity is formed by the enclosure of two baffles 31 and 32 and the side wall of the housing 1.

Specifically, in the embodiment, the baffle 31 on the outer side of the end cover 3 is provided with injection hole 33 and overflow hole 34.The colloid is injected into the cavity from the injection hole 33, and the colloid continuously occupies the internal space of the cavity during the injection process, thereby the air in the cavity is discharged from the overflow hole 34, and the colloid overflows from the overflow hole 34 after the colloid completely occupies the entire cavity.

In the past, when the power supply housing is encapsulated, it was necessary to vacuum the housing and fill the housing with sealing adhesive. If there is no vacuum inside the housing, the air holes in the sealing adhesive might be formed, and water vapor might enter the housing through the air holes, thus short-circuiting the components in the power supply housing. This kind of waterproof method has high requirements for equipment and low production efficiency.

In this embodiment, the connectivity principle is skillfully utilized, the injection hole and the overflow hole are arranged on the end cover by taking advantage of the feature that the injection of the colloid into the cavity takes up space and cause the gas in the cavity to be squeezed out, and the gas is discharged from the overflow hole during the injection process, which simplifies the operation of gas exhaust, but has the same good effect.

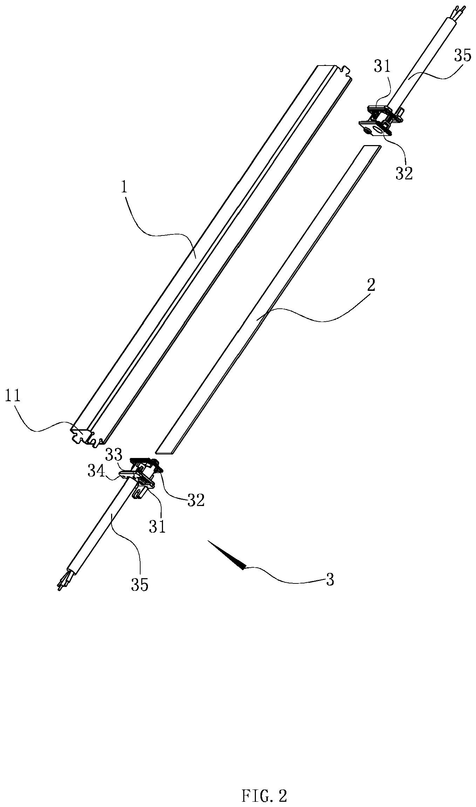

In order to further improve the sealing effect, reduce the trouble caused by the poor sealing effect, and at the same time reduce the production cost, simplifying the sealing step, the housing 1 is integrally formed as shown in figure 2 of the present embodiment. Preferably, the housing 1 is integrally formed with aluminum alloy, but it can of course be made of other materials. The housing is integrally designed. In this way, the place where the power supply may leak or need to be waterproof, the focus of the previous large area of the housing is reduced to the local area of the open end of the housing, that is, the reduction of the focus of waterproofing.

As shown in FIG.1-3, in the embodiment, the housing 1 has a square cylindrical design, and the openings are located at both ends of the cylinder. Of course, the opening on the housing 1 may also be one. The other end of the power supply in this structure is directly extended from the other end of the cylinder integral molding by the power cord.

correspondingly, the two baffles 31 and 32 of the end cover 3 are conductive plates and are connected by other conductive materials such as screws. The baffles 31, 32 and the opening 11 and the side wall of the housing 1 are combined into a cavity, and only part of the two ends of the cylinder are required to be injected at the time of sealing, and it saves costs.

The power supply component 2 is a circuit motherboard, which is set along the cylindrical direction, and the baffle 32 on the inner side of the end cover 3 is connected with one end of the circuit motherboard; the end cover 3 is further provided with power cord 35, and the power cord 35 is connected at least to the baffle 31 on the outer side of the end cover 3. The power cord is electrically connected to the circuit motherboard through the baffle made of the conductive material, and the baffle is in contact with the circuit motherboard face to face, which can effectively guarantee conduction performance, at the same time, this kind of structure can effectively avoid the problem that the connection between the power cord and the motherboard personally before, which is easy to appear the problem of bad contact caused by the virtual welding or the disconnection, and simplify the power structure.

It can be known that the two baffles 31 and 32 of the end cover 3 can also be integrally formed, and the specific structure is no longer repeat here; the colloid is a waterproof neutral silica gel, which is injected until it reaches IP6 level 8.

## Claims

1. A waterproof power supply, including:
housing (1), the housing (1) is provided with built-in power supply component (2);
end cover (3), the end cover (3) is connected to the opening (11) on the housing (1);
wherein the end cover (3) and the opening (11) of the housing (1) form a sealed cavity, and the sealing of end cover (3) and housing (1) can be realized by injecting colloid into the cavity, and
wherein the end cover (3) includes two oppositely disposed and connected baffles (31, 32), and the cavity is formed by the enclosure of two baffles (31, 32) and the side wall of the housing (1),
**characterized in that**
the two baffles (31, 32) are conductive plates and are electrically connected;
the power supply component (2) is a circuit motherboard, the baffle (32) on the inner side of the end cover (3) is connected with one end of the circuit motherboard;
the end cover (3) is further provided with power cord (35), and the power cord (35) is connected at least to the baffle (31) on the outer side of the end cover (3), and
that the two baffles (31, 32) are connected through a conductive connector.

2. The waterproof power supply of claim 1, wherein the baffle (31) on the outer side of the end cover (3) is provided with injection hole (33) and overflow hole (34), the colloid is injected into the cavity from the injection hole (33), the air in the cavity is discharged from the overflow hole (34) during the injection process, and the colloid overflows from the overflow hole (34) after the colloid is filled with the cavity.

3. The waterproof power supply of claim 1, wherein the housing (1) is integrally formed.

4. The waterproof power supply of claim 1, wherein two openings (11) are formed on the housing (1), respectively located at two ends of the housing (1).

5. The waterproof power supply of claim 1, wherein the two baffles (31, 32) are integrally formed.

## Patentansprüche

1. Wasserdichte Stromversorgung, umfassend:
ein Gehäuse (1), wobei das Gehäuse (1) mit einer eingebauten Stromversorgungskomponente (2) ausgestattet ist; eine Endabdeckung (3), wobei die Endabdeckung (3) ist mit einer Öffnung (11) an dem Gehäuse (1) verbunden ist;
wobei die Endabdeckung (3) und die Öffnung (11) des Gehäuses (1) einen abgedichteten Hohlraum bilden und die Abdichtung von der Endabdeckung (3) und dem Gehäuse (1) durch Einspritzen von Kolloid in den Hohlraum realisierbar ist, und
wobei die Endabdeckung (3) zwei gegenüberliegend angeordnete und miteinander verbundene Blenden (31, 32) aufweist und der Hohlraum durch die Umhüllung von zwei Blenden (31, 32) und einer Seitenwand des Gehäuses (1) gebildet wird,
**dadurch gekennzeichnet, dass**
die beiden Blenden (31, 32) leitende Platten und elektrisch verbunden sind;
die Stromversorgungskomponente (2) eine Schaltungshauptplatine ist, die Blende (32) auf der Innenseite der Endabdeckung (3) mit einem Ende der Schaltungshauptplatine verbunden ist; die Endabdeckung (3) ferner mit einem Netzkabel (35) versehen ist, und das Netzkabel (35) mindestens mit der Blende (31) auf der Außenseite der Endabdeckung (3) verbunden ist, und dass die beiden Blenden (31, 32) durch ein leitendes Verbindungsglied verbunden sind.

2. Wasserdichte Stromversorgung nach Anspruch 1, wobei die Blende (31) an der Außenseite der Endabdeckung (3) mit einer Einspritzöffnung (33) und einer Überlauföffnung (34) versehen ist, das Kolloid von der Einspritzöffnung (33) in den Hohlraum eingespritzt wird, die Luft im Hohlraum während des Einspritzvorgangs aus der Überlauföffnung (34) austritt und das Kolloid aus der Überlauföffnung (34) überläuft, nachdem das Kolloid in dem Hohlraum verfüllt ist.

3. Wasserdichte Stromversorgung nach Anspruch 1, wobei das Gehäuse (1) integral ausgebildet ist.

4. Wasserdichte Stromversorgung nach Anspruch 1, wobei zwei Öffnungen (11) an dem Gehäuse (1) ausgebildet sind, die sich jeweils an zwei Enden des Gehäuses (1) befinden.

5. Wasserdichte Stromversorgung nach Anspruch 1, wobei die beiden Blenden (31, 32) integral ausgebildet sind.

## Revendications

1. Une alimentation électrique étanche, comprenant:
un boîtier (1), le boîtier (1) étant pourvu d'un composant d'alimentation électrique intégré (2);
un couvercle d'extrémité (3), le couvercle d'extrémité (3) étant connecté à l'ouverture (11) sur le boîtier (1);
dans lequel le couvercle d'extrémité (3) et l'ouverture (11) du boîtier (1) forment une cavité étanche, et l'étanchéité du couvercle d'extrémité (3) et du boîtier (1) peut être réalisée en injectant du colloïde dans la cavité, et
dans lequel le couvercle d'extrémité (3) comprend deux cloisons opposées et connectées (31, 32), et la cavité est formée par l'enceinte de deux cloisons (31, 32) et la paroi latérale du logement (1),
**caractérisé en ce que**
les deux cloisons (31, 32) sont des plaques conductrices et sont connectées électriquement;
le composant d'alimentation (2) est une carte mère de circuit, la cloison (32) sur le côté intérieur du couvercle d'extrémité (3) étant connecté à une extrémité de la carte mère de circuit;
le couvercle d'extrémité (3) est en outre pourvu d'un cordon d'alimentation (35), et le cordon d'alimentation (35) est connecté à la/aux cloison(s) (31) sur le côté extérieur du couvercle d'extrémité (3), et
**en ce que** les deux cloisons (31, 32) sont connectées via un connecteur conducteur.

2. L'alimentation électrique étanche à l'eau de la revendication 1, dans laquelle la cloison (31) sur le côté extérieur du couvercle d'extrémité (3) est pourvue d'un trou d'injection (33) et d'un trou de trop-plein (34), le colloïde étant injecté dans la cavité à partir du trou d'injection (33), l'air dans la cavité étant évacué depuis le trou de trop-plein (34) pendant le processus d'injection, et le colloïde débordant du trou de trop-plein (34) après le remplissage de la cavité par le colloïde.

3. L'alimentation électrique étanche à l'eau selon la revendication 1, dans laquelle le boîtier (1) est formé d'un seul tenant.

4. L'alimentation électrique étanche à l'eau de la revendication 1, dans laquelle deux ouvertures (11) sont formées sur le boîtier (1), situées respectivement aux deux extrémités du boîtier (1).

5. L'alimentation électrique étanche à l'eau de la revendication 1, dans laquelle les deux cloisons (31, 32) sont formées d'un seul tenant.
